(19) Europäisches Patentamt / European Patent Office / Office européen des brevets

(11) **EP 3 320 586 B1**

(12) **FASCICULE DE BREVET EUROPEEN**

(45) Date de publication et mention de la délivrance du brevet:
**24.07.2019 Bulletin 2019/30**

(21) Numéro de dépôt: **16745793.6**

(22) Date de dépôt: **06.07.2016**

(51) Int Cl.:
*H01S 3/10* (2006.01)  *H01S 5/0687* (2006.01)
*H01S 3/13* (2006.01)  *H01S 3/08* (2006.01)
*H01S 3/16* (2006.01)  *H01S 5/024* (2006.01)
*H01S 5/068* (2006.01)  *H01S 3/0941* (2006.01)
*H01S 3/131* (2006.01)  *H01S 3/11* (2006.01)
*H01S 3/094* (2006.01)  *H01S 3/139* (2006.01)

(86) Numéro de dépôt international:
**PCT/FR2016/051714**

(87) Numéro de publication internationale:
**WO 2017/009542 (19.01.2017 Gazette 2017/03)**

(54) **LASER INJECTÉ ET PROCÉDÉ DE GÉNÉRATION D'IMPULSIONS LASER MULTIMODE LONGITUDINAL**

INJIZIERTER LASER UND VERFAHREN ZUR ERZEUGUNG LONGITUDINALER MULTIMODEN-LASERPULSE

INJECTED LASER AND METHOD FOR GENERATING LONGITUDINAL MULTIMODE LASER PULSES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.07.2015 FR 1501472**

(43) Date de publication de la demande:
**16.05.2018 Bulletin 2018/20**

(73) Titulaire: **Commissariat à l'Énergie Atomique et aux Énergies Alternatives 75015 Paris (FR)**

(72) Inventeurs:
• **PENNINCKX, Denis**
  **33610 Cestas (FR)**
• **LUCE, Jacques**
  **33470 Gujan-Mestras (FR)**
• **DIAZ, Romain**
  **33400 Talence (FR)**
• **BONVILLE, Odile**
  **33650 Cabanac (FR)**
• **COURCHINOUX, Roger**
  **33170 Gradignan (FR)**

(74) Mandataire: **Jacobacci Coralis Harle 32, rue de l'Arcade 75008 Paris (FR)**

(56) Documents cités:
**US-A- 5 027 360      US-A1- 2004 233 945**

• **FUJII Y ET AL: "DUAL-FREQUENCY PULSED LASER WITH AN ACCURATE GIGAHERTZ-BEAT NOTE", OPTICS LETTERS, OPTICAL SOCIETY OF AMERICA, US, vol. 32, no. 21, 1 novembre 2007 (2007-11-01), pages 3065-3067, XP001509586, ISSN: 0146-9592, DOI: 10.1364/OL.32.003065 cité dans la demande**
• **RAYMOND T D ET AL: "TWO-FREQUENCY INJECTION-SEEDED ND: YAG LASER", IEEE JOURNAL OF QUANTUM ELECTRONICS, IEEE SERVICE CENTER, PISCATAWAY, NJ, USA, vol. 31, no. 10, 1 octobre 1995 (1995-10-01), pages 1734-1737, XP000536234, ISSN: 0018-9197, DOI: 10.1109/3.466046 cité dans la demande**

**Description**

DOMAINE TECHNIQUE AUQUEL SE RAPPORTE L'INVENTION

La présente invention concerne de manière générale le domaine des dispositifs utilisant l'émission stimulée.

Elle concerne plus particulièrement le domaine des lasers pour la production et l'amplification d'ondes électro-magnétiques dans le domaine spectral ultraviolet, visible et/ou infrarouge.

Elle concerne en particulier un laser configuré pour fournir des impulsions laser de forte énergie ayant une intensité stable et un profil temporel d'intensité sans pics de modulation d'intensité et reproductible en fonction du temps.

ARRIERE-PLAN TECHNOLOGIQUE

Dans le présent document, on entend par rayonnement laser monomode longitudinal un rayonnement laser monochromatique et, respectivement, par rayonnement laser multimode longitudinal un rayonnement laser polychromatique.

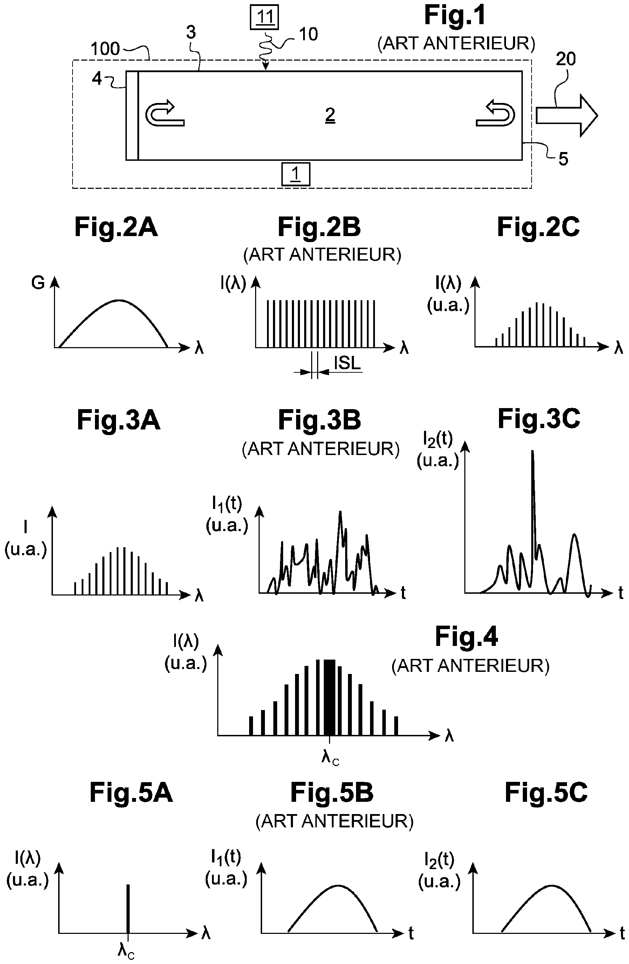

La figure 1 représente schématiquement une source laser 100 selon l'art antérieur. La source laser 100 comprend une source d'énergie de pompage 1, un milieu amplificateur optique 2 et une cavité résonante 3. Le milieu amplificateur optique 2 est un milieu adapté pour absorber l'énergie de la source d'énergie de pompage 1 en excitant des atomes (par exemple des ions terre rare, tels que des ions néodyme, ytterbium ou erbium) et qui peut générer, par émission stimulée, un rayonnement lumineux amplifié. Le milieu amplificateur optique 2 présente généralement une gamme spectrale d'amplification aussi appelée bande de gain G(λ) (exemple illustratif sur la Fig. 2A). Seules les longueurs d'ondes situées à l'intérieur de cette bande de gain G(λ) sont amplifiées. L'amplification peut se produire naturellement à partir du bruit de photons. La cavité laser 3 comporte deux extrémités 4, 5 entre lesquelles le rayonnement effectue un ou plusieurs aller-retour pour être amplifié progressivement. La cavité laser 3 définit parmi les longueurs d'ondes de la bande de gain, celles qui ont un gain substantiel lors de plusieurs aller-retour dans la cavité laser 3. Ces longueurs d'ondes discrètes sont appelées les modes de résonance ou modes longitudinaux de la cavité laser 3. En effet, la cavité résonante 3 amplifie sélectivement certaines fréquences optiques (ou les longueurs d'ondes correspondantes) et émet par conséquent un rayonnement lumineux cohérent. Plus précisément, la cavité résonante 3 détermine des longueurs d'ondes régulièrement espacées par un intervalle spectral libre (ISL ou FSR pour free spectral range). La Figure 2B représente schématiquement l'intensité I des modes longitudinaux la cavité résonante 3 en fonction la longueur d'onde λ. A la différence d'une diode électroluminescente (ou LED) qui ne comprend pas de cavité résonante 3 et qui émet un rayonnement non cohérent, une diode laser comporte une cavité résonante 3 et émet un rayonnement cohérent.

Pour générer des impulsions lasers, on utilise généralement un moyen de déclenchement. De manière connue en soi, le laser peut être déclenché de manière passive ou active par exemple au moyen d'un Q-switch.

A titre d'exemple, les lasers néodyme-YAG (Nd:YAG) sont capables de délivrer des impulsions laser nanosecondes de quelques joules à haute cadence et à une longueur d'onde de 1064nm. Les lasers Nd:YAG sont souvent doublés, triplés ou même quadruplés en fréquence pour obtenir des impulsions laser, respectivement à une longueur d'onde de 532 nm, 355nm ou 266nm. Ces lasers servent dans l'industrie pour diverses applications. Les lasers Nd:YAG ont deux modes de fonctionnement : non injecté et injecté.

En mode non injecté (illustré sur les figures 2-3), le laser à cavité ne comporte pas de source d'injection 11, mais uniquement un milieu amplificateur 2 dont la bande de gain G(λ) est représenté schématiquement sur la figure 2A et une cavité résonante 3 dont le spectre de fréquences de résonance est représenté schématiquement sur la figure 2B. Les impulsions laser se construisent à partir du bruit de photons. La figure 2C représente schématiquement l'intensité spectrale I(λ) d'une impulsion laser en sortie d'un laser en mode non injecté. En pratique, tous les modes longitudinaux de la cavité laser (Fig. 2C) situés à l'intérieur de la bande de gain G(λ) de l'amplificateur 2 (Fig. 2A) se retrouvent dans l'impulsion laser de sortie. Les longueurs d'ondes de sortie sont espacées régulièrement en fréquence de l'intervalle spectral libre de la cavité. Le laser à cavité non injecté émet donc un rayonnement 20 multimode longitudinal, ayant un spectre constitué des modes longitudinaux de la cavité laser. Ainsi, la plupart des sources lasers, ayant par exemple une énergie de l'ordre de quelques Joules et ne comportant pas de moyen spécifique de filtrage, émettent un rayonnement multimode longitudinal. Cependant, dans le cas d'un rayonnement laser à impulsions, par exemple de durée de l'ordre de quelques nanosecondes, les impulsions multimodes produites ont en général un profil temporel d'intensité bruité de manière aléatoire et non reproductible d'une impulsion ($I_1$(t) Fig. 3B) à une autre impulsion ($I_2$(t) Fig. 3C). Ces profils d'intensité I(t) présentent de fortes variations en fonction du temps faisant apparaître des modulations ou des pics d'intensité. Ces profils temporels d'intensité I(t) ne sont pas limités par la transformée de Fourier.

Le signal d'injection est modulé uniquement en phase.

Or, l'exposition d'un matériau à une impulsion laser présentant de tels pics d'intensité peut provoquer des effets non-linéaires indésirables, notamment une autofocalisation de l'impulsion par effet Kerr dans le matériau.

Si l'on souhaite une source laser monochromatique, il convient de privilégier l'amplification d'une raie laser à une longueur d'onde $\lambda_0$ déterminée.

Il existe différentes méthodes pour obtenir un laser monochromatique. La première méthode consiste à espacer les fréquences optiques de la cavité afin qu'il ne reste qu'une seule fréquence dans la bande de gain du milieu amplificateur. Ceci n'est réalisable que dans une cavité de dimension extrêmement petite, limitée à la génération de rayonnement de faible énergie, par exemple une diode laser. Une deuxième méthode consiste à disposer des moyens de filtrage, tel qu'un élément dispersif, par exemple un réseau de diffraction, pour filtrer une longueur d'onde spécifique, ce qui complique le laser.

Une autre méthode connue consiste à utiliser le laser à cavité en mode injecté. A cet effet, on utilise une source d'injection 11 en général continue, monochromatique et de faible puissance pour injecter un signal source 10 dans le laser à cavité.

On connaît notamment le document Y.K. Park et al., "Stable single-axial-mode operation of an unstable-resonator Nd:YAG oscillator by injection locking", Optics Letters, Vol. 5, pp. 96-98, 1980. La source d'injection 11 est un laser continu, de faible puissance, monochromatique dont la longueur d'onde $\lambda_0$ est accordée avec un des modes longitudinaux de la cavité résonante 3 du laser Nd:YAG (voir Figure 4). Le niveau initial de puissance de ce mode particulier est alors très supérieur à tous les autres modes qui sont au niveau du bruit de photons. Les impulsions laser amplifiées ont un spectre très étroit au voisinage de la longueur d'onde $\lambda_0$ de la source d'injection. L'utilisation d'une source d'injection monochromatique permet ainsi de sélectionner un mode longitudinal de cavité et de rendre monomode longitudinal un laser à cavité. En sortie de la cavité laser, on obtient des impulsions laser quasi monochromatiques (intensité spectrale $I(\lambda)$ Fig. 5A) et ayant une intensité stable, autrement dit ayant une forme temporelle limitée par la transformée de Fourier, sans pic, et ayant un profil temporel d'intensité reproductible d'une impulsion laser ($I_1(t)$ Fig. 5B) à une autre impulsion ($I_2(t)$ Fig. 5C).

Dans l'application aux tests d'endommagement de matériaux épais, il est souhaitable de générer des impulsions laser très énergétiques, de l'ordre de plusieurs Joules, pour aller jusqu'à la rupture du matériau. Cependant, une très forte énergie peut entraîner des effets de propagation non-linéaires importants. Or, en mode injecté classique, les impulsions étant quasi monochromatiques, la diffusion Brillouin stimulée rétrodiffuse une bonne partie de l'impulsion avant même qu'elle ait traversé le matériau testé. D'autre part en mode non injecté, les fluctuations temporelles induisent de l'autofocalisation par effet Kerr.

Pour certaines applications, il est donc souhaitable de disposer d'impulsions laser de forte énergie tout en évitant les effets non linéaires indésirables de rétrodiffusion Brillouin stimulée et d'autofocalisation par effet Kerr. On souhaite donc générer des impulsions laser de forte énergie ayant, premièrement, un spectre étendu pour éviter la diffusion Brillouin stimulée, deuxièmement, chaque impulsion laser ayant un profil temporel d'intensité sans pic d'intensité, c'est-à-dire une intensité stable au cours de chaque impulsion pour éviter l'autofocalisation par effet Kerr, et troisièmement ces impulsions laser ayant un profil temporel d'intensité reproductible d'une impulsion à l'autre.

On connaît un laser à injection utilisant deux lasers d'injection indépendants à deux longueurs d'ondes distinctes accordées respectivement sur différents modes longitudinaux de la cavité laser (voir par exemple les publications T. Raymond and A. Smith, "Two-frequency injection-seeded Nd:YAG laser", IEEE Journal of Quantum Electronics, Vol. 31, pp. 1734-1737, 1995 ; D. C. Kao et al., "Development of an amplitude-modulated Nd:YAG pulsed laser with modulation frequency tunability up to 60 GHz by dual seed injection", Optics Letters, Vol. 29, pp. 1203-1205, 2004 ; M. Katsuragawa and T. Onose, "Dual-wavelength injection-locked pulsed laser", Optics Letters, Vol. 30, pp. 1421-1423, 2005 ; T. Nakano et al., "Dual-frequency injection-locked nanosecond pulsed laser with arbitrary combination of two oscillation frequencies", Optics Express, Vol. 18, pp. 26409-26416, 2010). Cependant, chaque impulsion laser de sortie présente une intensité $I(t)$ en fonction du temps très fortement modulée périodiquement du fait du battement entre les deux lasers d'injection. Ces pics de modulation en intensité dans les impulsions laser de sortie sont susceptibles d'entraîner des effets non-linéaires indésirables. De plus les dérives du battement engendrent des variations d'une impulsion à l'autre.

D'autre part, on connaît un laser à injection utilisant un module d'injection constitué d'un seul laser continu dans lequel l'intensité de cette unique source laser d'injection est modulée en fonction du temps. Ainsi, la publication Y. Fujii, and M. Katsuragawa, "Dual-frequency pulsed laser with an accurate gigahertz-beat note," Optics Letters, Vol. 32, pp. 3065-3067, 2007 décrit une modulation sinusoïdale de l'intensité de la source d'injection à une fréquence de modulation égale à la moitié de intervalle spectral libre entre deux modes de la cavité. Cette modulation d'intensité de la source d'injection permet d'obtenir des impulsions laser de sortie ayant au plus deux ou trois modes longitudinaux. Toutefois, dans ce cas également, les impulsions laser générées ont une intensité dont le profil temporel $I(t)$ est fortement modulé en fonction du temps à l'intérieur d'une impulsion. Ces pics de modulation en intensité dans les impulsions laser de sortie sont susceptibles d'entraîner de l'autofocalisation par effet Kerr.

Le document US2004/0233945 A1 divulgue un laser injecté comprenant un milieu amplificateur optique disposé à l'intérieur d'une cavité laser ainsi qu'une seule source d'injection. Ledit laser injecté comporte en outre un dispositif de modulation optique de phase disposé entre la source d'injection et la cavité laser, le dispositif de modulation optique de phase étant configuré pour moduler périodiquement en fonction du temps une phase du rayonnement laser continu monochromatique émis par ladite source d'injection.

On souhaite générer des impulsions laser de forte énergie et/ou de forte puissance pour tester la résistance de matériaux ou de composants optiques vis à vis d'un endommagement par ces impulsions laser.

A cet effet, on souhaite générer des impulsions laser de forte énergie, tout en limitant le risque de générer ou de subir des effets non-linéaires indésirables : l'effet Kerr et la diffusion Brillouin stimulée lors d'interaction entre ces impulsions laser et un matériau.

OBJET DE L'INVENTION

Afin de remédier à l'inconvénient précité de l'état de la technique, la présente invention propose un laser injecté comprenant un milieu amplificateur optique disposé à l'intérieur d'une cavité laser déclenchée, le milieu amplificateur optique ayant une bande spectrale d'amplification, la cavité laser ayant un intervalle spectral libre inférieur à la largeur de bande spectrale du milieu amplificateur optique, la cavité laser déterminant des modes de résonance longitudinaux séparés spectralement par l'intervalle spectral libre.

Plus particulièrement, on propose selon l'invention un laser injecté comportant une seule source d'injection adaptée pour émettre un rayonnement laser continu monochromatique, le laser injecté comportant un dispositif de modulation optique de phase disposé entre la source d'injection et la cavité laser, le dispositif de modulation optique de phase étant configuré pour moduler périodiquement en fonction du temps une phase du rayonnement laser continu monochromatique à une fréquence de modulation égale à un multiple entier naturel de l'intervalle spectral libre de la cavité laser, de manière à ce que la source d'injection modulée en phase génère un rayonnement d'injection polychromatique ayant une pluralité de longueurs d'onde discrètes situées à l'intérieur de la bande de gain de l'amplificateur optique, la pluralité de longueurs d'onde discrètes étant accordée sur une pluralité de modes de résonance longitudinaux de la cavité laser, la cavité laser et le milieu amplificateur optique étant adaptés pour recevoir ledit rayonnement d'injection polychromatique et pour générer une impulsion laser multimode longitudinal.

Le laser injecté génère ainsi des impulsions laser ayant, d'une part, un spectre étendu et, d'autre part, une intensité stable dans le temps. Le spectre des impulsions laser est étendu sur plusieurs longueurs d'ondes discrètes, espacées les unes des autres d'un multiple entier de l'ISL. Chaque impulsion a un profil temporel d'intensité dépourvu de pics d'intensité ou de sur-modulation. Ces impulsions multimode longitudinal ont un profil temporel d'intensité stable dans le temps et reproductible d'une impulsion à l'autre.

Le nombre de longueurs d'onde discrètes et leur intensité relative peuvent être ajustés selon les besoins en fonction de la modulation de phase appliquée.

Le laser permet ainsi de délivrer des impulsions de forte énergie tout en évitant de générer ou de subir des effets non linéaires indésirables lors d'interaction entre ces impulsions laser et un matériau.

D'autres caractéristiques non limitatives et avantageuses du laser injecté conforme à l'invention, prises individuellement ou selon toutes les combinaisons techniquement possibles, sont les suivantes :

- le dispositif de modulation optique de phase est configuré pour moduler sinusoïdalement la phase du rayonnement laser continu monochromatique en fonction du temps avec une profondeur de modulation $m$, de manière à ce que le rayonnement d'injection polychromatique comporte environ $(2.m +1)$ longueurs d'ondes discrètes ;

- la profondeur de modulation est égale à environ 1,4 radian de manière à ce que le rayonnement d'injection polychromatique comporte environ trois longueurs d'ondes discrètes ;

- le laser injecté comprend un système d'asservissement à boucle de contre-réaction comprenant un dispositif de mesure adapté pour mesurer un signal représentatif d'une impulsion laser multimode longitudinal en sortie de la cavité laser et un dispositif de commande pour modifier, en fonction du signal mesuré, au moins un paramètre de fonctionnement de la source d'injection et/ou du dispositif de modulation optique de phase et/ou de la cavité laser ;

- la source d'injection comporte une diode laser alimentée par une source de courant électrique et le système de contre-réaction comporte un dispositif adapté pour modifier la puissance de la source de courant électrique alimentant la diode laser, de manière à modifier la longueur d'onde du rayonnement laser continu monochromatique en fonction du signal mesuré, de manière à ce que la longueur d'onde du rayonnement laser continu monochromatique corresponde à un mode longitudinal de la cavité laser ;

- le système à boucle de contre-réaction comporte un dispositif adapté pour modifier la fréquence de modulation et/ou la profondeur de modulation du dispositif de modulation optique de phase en fonction du signal mesuré ;

- le milieu amplificateur optique est choisi parmi un matériau ayant une matrice dopée titane, ytterbium ou néodyme, par exemple un cristal de néodyme-YAG ou un cristal de titane-saphir ;

- la cavité laser comporte un dispositif déclencheur d'impulsions à Q-switch;

- la source d'injection est une diode laser fibrée émettant un rayonnement laser continu monochromatique à une longueur d'onde de 1064 nm, le dispositif de modulation optique de phase comprend un modulateur optique à guide d'onde intégré sur substrat de niobate de lithium, le milieu amplificateur optique est un cristal de néodyme-YAG et la cavité laser déclenchée comprend un dispositif de déclenchement à Q-switch.

L'invention propose également un procédé de génération d'impulsions laser multimode longitudinal comprenant les étapes suivantes :

- émission d'un rayonnement laser continu monochromatique,
- modulation périodique, en fonction du temps, à une fréquence de modulation, d'une phase du rayonnement laser continu monochromatique de manière à générer un rayonnement d'injection polychromatique ayant une pluralité de longueurs d'ondes discrètes,
- injection du rayonnement d'injection polychromatique dans une cavité laser déclenchée comprenant un milieu amplificateur optique disposé à l'intérieur de la cavité laser, le milieu amplificateur optique ayant une bande spectrale d'amplification, et la cavité laser ayant un intervalle spectral libre inférieur à la largeur de bande spectrale du milieu amplificateur optique, la fréquence de modulation étant égale à un multiple entier naturel de l'intervalle spectral libre de la cavité laser, de manière à ce que la pluralité de longueurs d'ondes discrètes du rayonnement d'injection polychromatique soit accordée sur une pluralité de modes de résonance longitudinaux de la cavité laser situés à l'intérieur de la bande de gain de l'amplificateur optique,
- amplification du rayonnement d'injection polychromatique dans la cavité laser déclenchée, et
- déclenchement de l'émission d'une impulsion laser multimode longitudinal.

DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :

- la figure 1 représente schématiquement un laser à cavité selon l'art antérieur ;
- la figure 2 représente schématiquement la réponse spectrale d'un laser à cavité en mode non injecté ; la figure 2A illustre le gain d'un milieu amplificateur optique en fonction de la longueur d'onde G(λ) ; la figure 2B représente les modes de résonance longitudinaux d'une cavité laser ; et la figure 2C représente schématiquement l'intensité spectrale I(λ) d'un laser à cavité non injecté ;
- la figure 3A représente schématiquement l'intensité spectrale I(λ) d'un laser à cavité non injecté de l'art antérieur, la figure 3B, respectivement 3C, représente le profil temporel d'intensité $I_1(t)$ d'une première impulsion laser, respectivement $I_1(t)$ d'une deuxième impulsion laser, en sortie de ce laser à cavité non injecté de l'art antérieur ;

- la figure 4 représente schématiquement une longueur d'onde d'injection accordée sur un mode de résonance d'un laser en mode injecté de l'art antérieur ;
- la figure 5A représente schématiquement l'intensité spectrale I(λ) quasi monochromatique d'un laser à cavité injecté de l'art antérieur, la figure 5B, respectivement 5C, représente le profil temporel d'intensité $I_1(t)$ d'une première impulsion laser quasi monochromatique, respectivement $I_2(t)$ d'une deuxième impulsion laser quasi monochromatique, en sortie de ce laser à cavité injecté de l'art antérieur ;

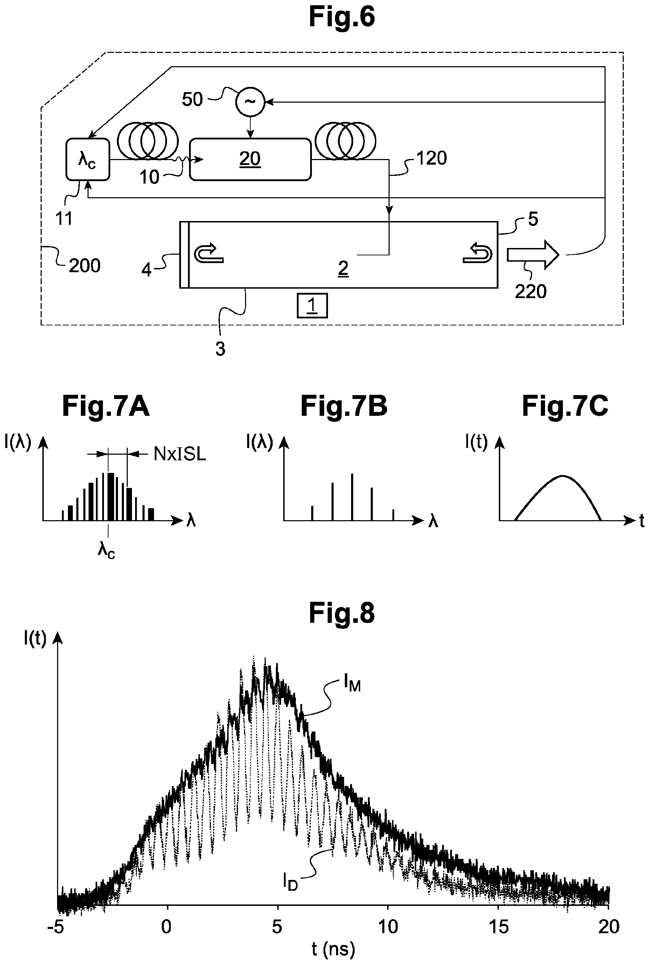

- la figure 6 représente schématiquement un laser injecté selon un mode de réalisation de l'invention ;
- la figure 7A représente schématiquement l'intensité spectrale I(λ) d'une source d'injection modulée en phase, en superposition avec le spectre d'un laser à cavité ; la figure 7B représente l'intensité spectrale d'une impulsion laser en sortie d'un laser multimode longitudinal injecté par une source d'injection modulée en phase et la figure 7C représente un profil temporel d'intensité $I_1(t)$ d'une impulsion laser multimode longitudinal en sortie de ce laser à cavité injecté par une source d'injection modulée en phase ;
- la figure 8 représente une mesure d'intensité spectrale d'impulsion laser en sortie d'une cavité laser injectée par une source d'injection modulée en phase désaccordée et respectivement par une source d'injection modulée en phase accordée sur des modes longitudinaux de la cavité laser.

La présente divulgation propose un laser à impulsion multimode longitudinal qui permet de supprimer de nombreux effets non linéaires indésirables lors d'interactions laser-matière.

En effet, différents effets non linéaires indésirables, notamment la diffusion Brillouin Stimulée (BS) et/ou l'effet Kerr, sont susceptibles de se produire lors d'interactions entre un matériau et des impulsions laser.

La diffusion Brillouin Stimulée (BS) est un effet non linéaire qui résulte d'une excitation des résonances dans le cristal d'un matériau soumis à un rayonnement laser. Cet effet non linéaire apparaît en fonction de la densité spectrale de puissance, pour une même énergie. Il existe une largeur Brillouin, aussi appelée temps caractéristique Brillouin, qui dépend de chaque matériau et de la longueur d'onde incidente.

L'effet Kerr est un effet non linéaire lié à l'intensité de l'impulsion laser et induit une modification de l'indice de réfraction du matériau. L'effet Kerr est susceptible d'induire la formation d'une lentille dans le matériau produisant une autofocalisation du faisceau laser.

La présente divulgation permet de réduire les risques d'effets non linéaires susceptibles d'apparaître et de gêner les tests de résistance des matériaux aux effets laser.

Dispositif

Sur la figure 6, on a représenté un laser injecté 200 selon un mode de réalisation de l'invention.

Le laser injecté 200 comporte une seule et unique source d'injection 11. De préférence, cette source comporte une source laser continue temporellement. La source d'injection 11 émet un rayonnement laser continu monochromatique 10 à une longueur d'onde $\lambda_c$.

La source d'injection 11 est par exemple une diode laser fibrée de longueur d'onde $\lambda_c$ égale à 1064,2 nm. La diode laser émet un rayonnement continu et a une puissance de l'ordre de quelques milliwatts à quelques dizaines de milliwatts.

Le laser 200 comporte un milieu amplificateur optique 2 disposé à l'intérieur d'une cavité laser 3 déclenchée généralement par Q-switch. La longueur d'onde $\lambda_c$ de la source d'injection 11 est sélectionnée dans la bande de gain du milieu amplificateur optique 2 et de préférence au voisinage d'un mode longitudinal de la cavité laser 3.

De plus, le laser injecté 200 comprend un modulateur optique de phase 20 disposé entre la source d'injection 11 et la cavité laser 3. Le modulateur optique de phase 20 est excité à une fréquence de modulation $f_m$ et avec une profondeur ou une amplitude de modulation $m$ déterminée.

La forme de la modulation de phase périodique la plus courante est de type sinusoïdale, sans synchronisation. Dans le cas d'une modulation sinusoïdale, la modulation de phase suit l'équation :

$$\varphi(t) = m \cdot \sin(2\pi . f_m . t)$$

De manière alternative, toute autre forme de modulation périodique peut être appliquée telle qu'une forme carrée, triangulaire ou en dents de scie.

A titre d'exemple, le modulateur optique de phase 20 est un modulateur à guide d'onde intégré sur substrat de niobate de lithium (LiNbO$_3$). L'application d'une tension de modulation entre les électrodes du modulateur intégré permet de de commander un déphasage modulé en fonction du temps. Par exemple, la tension de modulation peut être sinusoïdale, à une fréquence de modulation $f_m$ dans la gamme radio-fréquence (rf), de l'ordre de plusieurs centaines de mégahertz. L'amplitude de la tension appliquée détermine la profondeur de modulation $m$. Par exemple, une tension appliquée de 5-6 volts d'amplitude sur un modulateur à guide d'onde intégré permet d'obtenir une profondeur de modulation $m$ = 1,4 radian de manière à moduler la phase entre -1,4 radian et +1,4 radian.

Le modulateur optique de phase 20 est disposé entre la source d'injection 11 et la cavité laser 3 sur un chemin optique du rayonnement laser continu monochromatique 10.

Le modulateur optique de phase 20 module la phase du rayonnement laser continu monochromatique 10 de longueur d'onde $\lambda_c$. Ici, le modulateur optique de phase 20 ne module pas l'intensité du rayonnement laser continu monochromatique 10. Ainsi l'intensité du rayonnement d'injection reste stable en fonction du temps.

En sortie du modulateur optique de phase 20, on obtient un rayonnement d'injection 120 continu temporellement et modulé en phase à la fréquence de modulation $f_m$. Dans le domaine spectral, par application d'une transformée de Fourier, le rayonnement d'injection continu et modulé en phase 120 présente une pluralité de longueurs d'onde discrètes et forme ainsi un rayonnement d'injection à la fois continu temporellement et polychromatique 120.

Le nombre des raies spectrales, leurs longueurs d'ondes respectives et l'intensité relative des raies spectrales aux longueurs d'ondes discrètes du rayonnement d'injection continu modulé en phase 120 sont fonction de la longueur d'onde $\lambda_c$ du rayonnement laser continu monochromatique 10, de la fréquence de modulation $f_m$ et de la profondeur de modulation $m$.

Plus précisément, on considère un modulateur de phase appliquant une modulation sinusoïdale à une fréquence de modulation $f_m$ dans le domaine du mégahertz (MHz) au gigahertz (GHz) avec une profondeur de modulation $m$. Le modulateur de phase génère des raies de Bessel dans le spectre du rayonnement d'injection 120. Le nombre de raies et la hauteur relative des raies sont fonction de la profondeur de modulation $m$. Le nombre de raies environ égal à $(2.m+1)$. Ces raies spectrales sont réparties autour de la longueur d'onde $\lambda_c$ du rayonnement laser continu. Ces raies spectrales sont espacées les unes des autres, dans le domaine des fréquences optiques, de la fréquence de modulation $f_m$.

Un premier exemple de réalisation particulièrement intéressant correspond à la valeur de profondeur de modulation $m=1,4$ rad. En effet, cette première valeur particulière permet de générer essentiellement trois raies spectrales principales et deux raies spectrales annexes d'intensité plus faible, les autres raies de Bessel étant d'intensité quasi-nulle. Les trois raies spectrales principales sont égales en intensité, la raie centrale étant centrée sur la longueur d'onde $\lambda_c$ et les trois raies principales étant espacées en fréquence optique de la fréquence de modulation $f_m$. On rappelle que la fréquence optique $f$ est reliée à la longueur d'onde $\lambda$ par la relation bien connue :

$$f = \frac{c}{\lambda}$$

où c représente la célérité de la lumière.

Un deuxième exemple de réalisation intéressant correspond à la valeur de profondeur de modulation *m=2,4 rad.* Cette deuxième valeur particulière permet d'annuler la raie centrale et de générer au total environ six raies, espacées en fréquence optique de la fréquence de modulation $f_m$ et disposées symétriquement par rapport à cette raie centrale. La raie centrale d'intensité nulle est située à la longueur d'onde $\lambda_c$ de la source d'injection 11 monochromatique.

Dans un autre exemple, une valeur de profondeur de modulation *m*=10 radians permet de générer environ 21 raies spectrales.

On note qu'il n'est pas nécessaire que les raies discrètes soient équidistantes. Il est possible qu'une ou plusieurs raies soient annulées entre deux raies discrètes. De même, il n'est pas nécessaire que les raies discrètes correspondent à tous les modes longitudinaux de la cavité situés à l'intérieur de la bande spectrale de l'amplificateur. Selon les applications, il suffit d'au moins deux ou trois raies accordées à des modes longitudinaux et situées dans la bande de gain de l'amplificateur optique.

On sélectionne les raies polychromatiques de manière à ce qu'elles coïncident avec des modes longitudinaux de la cavité laser et à ce qu'elles soient à l'intérieur de la bande de gain de l'amplificateur optique.

Pour cela, une première condition est de choisir la fréquence de modulation $f_m$ de manière à ce qu'elle soit égale à un multiple entier de l'intervalle spectral libre (ISL) : $f_m = N.ISL$ où N est un nombre entier naturel supérieur ou égal à 1. Par exemple, pour une cavité laser 3 ayant un intervalle spectral libre de 180 MHz, on choisit par exemple une fréquence de modulation $f_m$ égale à 360 MHz ou 540 MHz. Le générateur de fréquence qui commande le modulateur optique de phase est en général assez stable. En pratique la fréquence de modulation est de l'ordre de quelques centaines de mégahertz et la précision nécessaire sur cette fréquence de modulation est de l'ordre du mégahertz, ce qui est facilement accessible avec un générateur de fréquence courant. La première condition est aisément remplie en réglant la fréquence de modulation $f_m$. Cette fréquence de modulation $f_m$ ne requiert en général pas d'asservissement.

De plus, les longueurs d'ondes discrètes des raies doivent être situées dans la bande de gain de l'amplificateur optique et de préférence avec un gain similaire. En effet, dans le cas où les raies correspondent à des valeurs de gain très différentes, une sur-modulation FM-AM parasite est susceptible d'apparaître. Il est donc préférable que les raies se situent dans une zone relativement plate de la bande de gain de l'amplificateur optique.

Par exemple dans le cas d'un amplificateur optique basé sur un cristal de Nd :YAG, qui est un des matériaux amplificateur ayant une bande de gain étroite, les raies se situent dans une bande spectrale de 20 à 30 GHz.

Dans le cas des matériaux ayant une très grande largeur de bande, tels qu'un laser titane-saphir ou un laser à ytterbium, cette condition supplémentaire n'est pas limitative.

Une difficulté technique consiste à réaliser l'accord entre les longueurs d'onde du rayonnement continu polychromatique d'injection 120 et certains modes longitudinaux de la cavité laser 3.

Pour cela, la fréquence de modulation étant fixée à un multiple de l'intervalle spectral libre de la cavité laser, une deuxième condition est d'assurer la correspondance exacte ou l'accord entre la longueur d'onde discrète d'une des raies et un mode longitudinal de la cavité laser situé à l'intérieur de la bande de gain de l'amplificateur optique. Or, cette correspondance doit être réalisée avec une précision à mieux qu'environ un dixième de l'intervalle spectral libre, soit environ 20 MHz, ce qui pose une contrainte forte sur la précision du réglage en longueur d'onde du rayonnement continu polychromatique d'injection 120.

Par exemple, dans le cas où la profondeur de modulation *m=1,4 radian* il s'agit d'accorder la longueur d'onde de la raie centrale $\lambda_c$ correspondant à une fréquence optique de l'ordre de 300 THz à un mode longitudinal du laser à cavité avec une précision de l'ordre de 20 MHz, c'est-à-dire avec une précision de l'ordre de $10^{-7}$.

Dans un mode de réalisation illustré sur la figure 6, cet accord est réalisé en modifiant la longueur d'onde $\lambda_c$ du rayonnement laser continu monochromatique 10 émis par la source d'injection 11.

Dans un exemple de réalisation, la source d'injection 11 monochromatique est une diode laser. On met à profit les propriétés thermo-optiques de ce type de diode laser. En effet, une diode laser présente généralement un chirp adiabatique, noté $\kappa$, qui permet de modifier légèrement la longueur d'onde d'émission lorsque le courant d'alimentation de la diode laser est modifié, ce qui modifie aussi la puissance de la diode laser. Ainsi, une très faible modification de la puissance d'une diode laser suffit pour changer la longueur d'onde, avec la précision requise indiquée dans l'application ci-dessus. Par exemple, considérons une diode laser monomode 1 courante fonctionnant aux alentours de 10mW et ayant un chirp adiabatique $\kappa \sim 10^{11}$ Hz/W. Une variation de puissance de la diode laser de l'ordre du pourcent correspond à une variation de la longueur d'onde du rayonnement monochromatique d'environ 10MHz.

Dans une variante, on modifie le courant électrique d'un module à effet Peltier qui stabilise la température d'une diode de pompe, de manière à modifier les propriétés thermiques de la jonction, qui affectent la longueur d'onde du rayonnement laser continu monochromatique 10. L'avantage de cette variante est que la puissance de la diode laser 11 n'est pas modifiée. Toutefois, dans cette variante, le changement de longueur d'onde, dû à un effet thermique, n'est pas instantané.

Après modulation de phase de ce rayonnement laser continu monochromatique 10, les raies discrètes sont ainsi décalées simultanément de manière à correspondre avec certains modes longitudinaux de la cavité laser.

Sur la figure 6, le laser injecté comporte avantageusement un système d'asservissement à boucle de contre-réaction. Ce système d'asservissement comprend un dispositif de mesure d'une propriété de l'impulsion de sortie 220. Par exemple, on mesure la forme temporelle de l'impulsion de sortie 220. Un système électronique et/ou numérique compare la forme temporelle mesurée à une forme temporelle de référence. L'asservissement a pour but d'assurer que la forme temporelle de l'impulsion laser de sortie 200 ne change pas par rapport au gabarit en fonction du temps.

De préférence, on asservit la longueur d'onde $\lambda_0$ du rayonnement monochromatique de manière à assurer la stabilité de l'accord entre les longueurs d'ondes discrètes du rayonnement polychromatique et certains modes longitudinaux de la cavité laser. Eventuellement, on peut aussi asservir la fréquence de modulation du modulateur optique de phase 20.

De façon alternative, on peut réaliser une contre-réaction sur la longueur de la cavité laser 3. La distance entre les extrémités 4 et 5 de la cavité laser détermine en effet les longueurs d'ondes des modes longitudinaux de la cavité laser 3. Cet ajustement de la longueur de la cavité laser permet de modifier l'intervalle spectral libre et/ou la longueur d'onde des modes longitudinaux de la cavité laser.

Toutefois, il est en général plus simple d'asservir une diode laser de source ou de pompe. Dans ce cas, on stoppe la boucle de contre-réaction de la cavité laser 3.

Ainsi, on injecte dans la cavité laser 3, un rayonnement temporellement continu et polychromatique, à des longueurs d'ondes discrètes, séparées en fréquence optique d'au moins la fréquence de modulation $f_m$. Cette modulation de phase permet de générer des raies espacées d'au moins plusieurs centaines de MHz, de 1GHz ou même de 10 à 15 GHz. Cet espacement entre modes longitudinaux est suffisant pour éviter de générer des effets non linéaires indésirables dans les matériaux.

Dans un exemple de réalisation, la source d'injection monochromatique est une diode laser fibrée. Le modulateur de phase est un modulateur à guide d'onde intégré sur substrat de LiNbO$_3$. Le modulateur de phase est excité par un signal rf sinusoïdal, avec une tension de modulation de 5-6 volts, de manière à obtenir une profondeur de modulation m= 1,4 rad.

En sortie du modulateur optique de phase 20, une fibre optique guide le rayonnement continu polychromatique 120 vers la cavité résonante 3. En sortie de la fibre optique, un collimateur en espace permet d'injecter le faisceau dans la cavité. Le faisceau a un diamètre 3-4 mm et est peu divergent.

Un polariseur à fuite permet de coupler le rayonnement continu polychromatique dans la cavité résonante 3.

Les photons de la source d'injection sont injectés en continu dans la cavité laser 3, avec un espacement spectral adéquat (condition 1) et à la longueur d'onde adéquate (condition 2).

Au bout de 10 à 20 aller-retour dans la cavité de grand gain, une impulsion sort, ayant une puissance de l'ordre du MW.

De façon avantageuse, on dispose un déclencheur de type Q-switch dans la cavité laser 3. Les impulsions de durée 6-7 ns sortent à la vitesse de déclenchement du Q-switch, à une fréquence de répétition d'environ 100 Hz.

La forme temporelle des impulsions de sortie est donnée naturellement par le matériau amplificateur optique 2.

La figure 7A représente schématiquement un exemple de spectre en intensité d'un laser à cavité en mode non injecté, les modes longitudinaux de la cavité laser étant représentés en traits fins. La figure 7A représente aussi le spectre en intensité d'un laser à cavité en mode injecté avec modulation de phase d'une source d'injection monochromatique, ce spectre du laser étant constitué de raies discrètes, représentées en traits épais. Dans cet exemple illustratif, on observe que l'espacement entre raies du laser à cavité en mode injecté modulé en phase est égal à trois fois l'intervalle spectral libre (ISL) de la cavité laser, les raies discrètes étant équidistantes en fréquence.

La figure 7B représente schématiquement le spectre en intensité d'une impulsion laser en sortie de la cavité laser dans laquelle on a injecté le rayonnement polychromatique généré par modulation de phase. L'impulsion laser de sortie est aussi multimode longitudinal et comporte la pluralité de longueurs d'ondes discrètes injectées par la source d'injection modulée en phase.

La figure 7C représente schématiquement la forme temporelle d'une impulsion laser en sortie de la cavité laser. Cette forme temporelle est reproductible d'une impulsion à l'autre et ne présente pas de pics de modulation.

Plus précisément, la figure 8 représente en fonction du temps la forme temporelle (ou intensité en fonction du temps) $I_D$ d'une impulsion laser en sortie d'une cavité laser injectée avec une modulation de phase à une fréquence de modulation $f_m$ d'environ 1,8 GHz, cette fréquence de modulation étant désaccordée par rapport à l'intervalle spectral libre de la cavité. La forme temporelle de l'impulsion laser désaccordée $I_D$ présente une forte modulation et des pics d'intensité. Comme expliqué plus haut, de tels pics d'intensité sont indésirables lorsqu'on souhaite éviter l'autofocalisation par effet Kerr.

La figure 8 représente aussi la forme temporelle d'une autre impulsion laser $I_M$ en sortie de la même cavité laser injectée avec une modulation de phase à une fréquence de modulation de 1,83 GHz, correspondant à 10 fois l'ISL et la longueur d'onde $\lambda c$ correspondant à un des modes de la cavité laser. Ainsi, Cette fréquence de modulation de 1,83 GHz permet de remplir la condition d'accord entre les longueurs d'ondes injectées et des modes longitudinaux de la cavité, cette modulation de phase étant stabilisée. Un effet surprenant est que la forme temporelle de cette impulsion $I_M$ est stabilisée, cette forme temporelle étant dépourvue de pics d'intensité. Cet effet est surprenant car on pouvait s'attendre à ce que la modulation de phase génère une sur-modulation de la forme temporelle de l'impulsion comme dans le cas de la modulation désaccordée à 1,8 GHz.

L'impulsion laser 220 en sortie d'un laser injecté modulé en phase et stabilisé présente :

- une répartition spectrale d'énergie sur plusieurs raies correspondant à des modes longitudinaux de la cavité laser ;
- une forme temporelle stable, sans pics de sur-modulation ; et
- une intensité stable d'une impulsion à une autre impulsion.

Une impulsion laser 220 de forte énergie ayant les propriétés énoncées ci-dessus permet de réduire les effets non-linéaires indésirables tels que notamment l'autofocalisation de l'impulsion laser par effet Kerr et la diffusion Brillouin stimulée dans un matériau exposé à cette impulsion laser. En effet, d'une part, la suppression des pics d'intensité dans le profil temporel de chaque impulsion permet de supprimer l'effet Kerr. D'autre part, la répartition spectrale d'énergie multimode permet de réduire l'effet de diffusion Brillouin.

La modulation de phase de la source d'injection présente plusieurs avantages. Cette modulation de phase ne limite pas le nombre de raies spectrales du rayonnement polychromatique d'injection. En augmentant le nombre de raies spectrales, il est ainsi possible de réduire la densité spectrale de puissance des impulsions et d'éliminer encore mieux les effets non linéaires de diffusion Brillouin. Afin de réduire ou de supprimer tout effet Brillouin, on choisit en pratique la fréquence de modulation $f_m$ supérieure ou égale à l'inverse du temps caractéristique Brillouin.

Dans un exemple d'application : 1/t Brillouin ~ 500 MHz

On choisit un écart entre raies $\geq$ ~ 500 MHz

D'autre part, dans des applications demandant une puissance des impulsions encore plus élevées, il suffit de modifier la profondeur de modulation pour augmenter le nombre de raies spectrales.

L'invention peut trouver des applications dans le domaine des interactions laser-matière et en particulier dans les tests d'endommagement des matériaux exposés à des impulsions laser de forte énergie.

L'invention peut également trouver des applications dans le domaine des LIDAR pour générer des impulsions laser polychromatiques ayant une intensité stable dans le temps et reproductibles.

**Revendications**

1. Laser injecté (200) comprenant :

- un milieu amplificateur optique (2) disposé à l'intérieur d'une cavité laser (3) déclenchée, le milieu amplificateur optique (2) ayant une bande spectrale d'amplification,
- la cavité laser (3) ayant un intervalle spectral libre (ISL) inférieur à la largeur de bande spectrale du milieu amplificateur optique (2), la cavité laser (3) déterminant des modes de résonance longitudinaux séparés spectralement par l'intervalle spectral libre (ISL),
de surcroît :

- le laser injecté (200) comporte une seule source d'injection (11) adaptée pour émettre un rayonnement laser continu monochromatique (10),
- le laser injecté (200) comporte un dispositif de modulation optique de phase (20) disposé entre la source d'injection (11) et la cavité laser (3), le dispositif de modulation optique de phase (20) étant configuré pour moduler périodiquement en fonction du temps une phase du rayonnement laser continu monochromatique (10) à une fréquence de modulation ($f_m$) égale à un multiple entier naturel de l'intervalle spectral libre (ISL) de la cavité laser (3), de manière à ce que la source d'injection modulée en phase génère un rayonnement d'injection polychromatique (120) ayant une pluralité de longueurs d'ondes discrètes situées à l'intérieur de la bande de gain de l'amplificateur optique, la pluralité de longueurs d'onde discrètes étant accordée sur une pluralité de modes de résonance longitudinaux de la cavité laser (3),
- la cavité laser (3) et le milieu amplificateur optique (2) étant adaptés pour recevoir ledit rayonnement d'injection polychromatique (120) et pour générer une impulsion laser multimode longitudinal (220).

2. Laser injecté (200) selon la revendication 1 dans lequel le dispositif de modulation optique de phase (20) est configuré pour moduler sinusoïdalement la phase du rayonnement laser continu monochromatique (10) en fonction du temps avec une profondeur de modulation ($m$), de manière à ce que le rayonnement d'injection polychromatique (120) comporte environ (2. $m$ +1) longueurs d'onde discrètes.

3. Laser injecté (200) selon la revendication 2 dans lequel la profondeur de modulation ($m$) est égale à environ 1,4 radians de manière à ce que le rayonnement d'injection polychromatique (120) comporte trois longueurs d'onde discrètes.

4. Laser injecté (200) selon l'une des revendications 1 à 3 comprenant un système d'asservissement à boucle de contre-réaction comprenant un dispositif de mesure adapté pour mesurer un signal représentatif d'une impulsion laser multimode longitudinal (220) en sortie de la cavité laser (3) et un dispositif de commande pour modifier, en fonction du signal mesuré, au moins un paramètre de fonctionnement de la source d'injection (11) et/ou du dispositif de modulation optique de phase (20) et/ou de la cavité laser (3).

5. Laser injecté (200) selon la revendication 4 dans lequel la source d'injection (11) comporte une diode laser alimentée par une source de courant électrique et dans lequel le système de contre-réaction comporte un dispositif adapté pour modifier la puissance de la source de courant électrique alimentant la diode laser, de manière à modifier la longueur d'onde du rayonnement laser continu monochromatique (10) en fonction du signal mesuré.

6. Laser injecté (200) selon l'une des revendications 4 ou 5 dans lequel le système de contre-réaction comporte un dispositif adapté pour modifier la fréquence de modulation ($f_m$) et/ou la profondeur de modulation ($m$) du dispositif de modulation optique de phase (20) en fonction du signal mesuré.

7. Laser injecté (200) selon l'une des revendications 1 à 6 dans lequel le milieu amplificateur optique (2) est choisi parmi un matériau ayant une matrice dopée titane, ytterbium ou néodyme.

8. Laser injecté (200) selon l'une des revendications 1 à 7 dans lequel la source d'injection (11) est une diode laser fibrée émettant un rayonnement laser continu monochromatique (10) à une longueur d'onde ($\lambda_c$) de 1064 nm, le dispositif de modulation optique de phase (20) comprend un modulateur optique à guide d'onde intégré sur substrat de niobate de lithium, le milieu amplificateur optique (2) est un cristal de néodyme-YAG et la cavité laser (3) déclenchée comprend un dispositif de déclenchement à Q-switch.

9. Procédé de génération d'impulsions laser multimode longitudinal (220) comprenant les étapes suivantes :

- émission d'un rayonnement laser continu monochromatique (10),
- modulation périodique, en fonction du temps, à une fréquence de modulation ($f_m$), d'une phase du rayonnement laser continu monochromatique (10) de manière à générer un rayonnement d'injection polychromatique (120) ayant une pluralité de longueurs d'ondes discrètes,
- injection du rayonnement d'injection polychromatique (120) dans une cavité laser (3) déclenchée comprenant un milieu amplificateur optique (2) disposé à l'intérieur de la cavité laser (3), le milieu amplificateur optique (2) ayant une bande spectrale d'amplification, et la cavité laser ayant un intervalle spectral libre (ISL) inférieur à la largeur de bande spectrale du milieu amplificateur optique (2), la fréquence de modulation ($f_m$) étant égale à un multiple entier naturel de l'intervalle spectral libre (ISL) de la cavité laser (3), de manière à ce que la pluralité de longueurs d'ondes discrètes du rayonnement d'injection polychromatique (120) soit accordée sur une pluralité de modes de résonance longitudinaux de la cavité laser (3) situés à l'intérieur de la bande de gain de l'amplificateur optique,
- amplification du rayonnement d'injection polychromatique (120) dans la cavité laser déclenchée, et
- déclenchement de l'émission d'une impulsion laser multimode longitudinal (220).

**Patentansprüche**

1. Induzierter Laser (200) mit

- einem im Inneren eines getriggerten Laserresonators (3) angeordneten optischen Verstärkungsmedium (2), wobei das optische Verstärkungsmedium (2) ein spektrales Verstärkungsband aufweist,
- wobei der Laserresonator (3) einen freien Spektralbereich (ISL) aufweist, der kleiner als die spektrale Bandbreite des optischen Verstärkungsmediums (2) ist, wobei der Laserresonator (3) longitudinale Resonanzmoden bestimmt, die durch den freien Spektralbereich (ISL) getrennt sind,
wobei außerdem
- der induzierte Laser (200) eine einzige Laserinjektionsquelle (11) aufweist, die dazu ausgelegt ist, eine monochromatische kontinuierliche Laserstrahlung (10) auszusenden,
- wobei der induzierte Laser (200) eine optische Phasenmodulationsvorrichtung (20) aufweist, die zwischen der Injektionsquelle (11) und dem Laserresonator (3) angeordnet ist, wobei die optische Phasenmodulationsvorrichtung (20) dazu ausgelegt ist, eine Phase der monochromatischen kontinuierlichen Laserstrahlung (10) periodisch in Abhängigkeit von der Zeit bei einer Modulationsfrequenz ($f_m$) zu modulieren, die gleich einem ganzen natürlichen Vielfachen des freien Spektralbereichs (ISL) des Laserresonators (3) ist, damit die phasenmodulierte Injektionsquelle eine polychromatische Injektionsstrahlung (120) erzeugt, die eine Anzahl diskreter Wellenlängen aufweist, die innerhalb des Verstärkungsbands des optischen Verstärkers liegen, wobei die Anzahl diskreter Wellenlängen auf eine Anzahl longitudinaler Resonanzmoden des Laserresonators (3) abgestimmt ist,
- wobei der Laserresonator (3) und das optische Verstärkermedium (2) dazu ausgelegt sind, die polychromatische Injektionsstrahlung (120) zu empfangen und einen longitudinalen Multimoden-Laserimpuls (220) zu erzeugen.

2. Induzierter Laser (200) gemäß Anspruch 1, bei dem die optische Phasenmodulationsvorrichtung (20) dazu ausgelegt ist, die monochromatische kontinuierliche Laserstrahlung (10) sinusartig in Abhängigkeit von der Zeit mit einer Modulationstiefe (m) so zu modulieren, daß die polychromatische Injektionsstrahlung (120) ungefähr $(2 \cdot m + 1)$ diskrete Wellenlängen aufweist.

3. Induzierter Laser (200) gemäß Anspruch 2, bei dem die Modulationstiefe (m) ungefähr gleich 1,4 rad ist, damit die polychromatische Injektionsstrahlung (120) drei diskrete Wellenlängen aufweist.

4. Induzierter Laser (200) gemäß einem der Ansprüche 1 bis 3, mit einem Ansteuersystem mit Rückkopplungsschleife, das eine Meßvorrichtung zum Messen eines für einen longitudinalen Multimoden-Laserimpuls (220) repräsentativen Signals am Ausgang des Laserresonators (3) aufweist, und einer Steuerungsvorrichtung zum Modifizieren wenigstens eines Betriebsparameters der Injektionsquelle (11) und/oder der optischen Phasenmodulationsvorrichtung (20) und/oder des Laserresonators (3).

5. Induzierter Laser (200) gemäß Anspruch 4, bei dem die Injektionsquelle (11) eine durch eine elektrische Stromquelle versorgte Laserdiode aufweist und bei dem das Rückkopplungssystem eine Vorrichtung aufweist, die dazu ausgelegt ist, die Leistung der die Laserdiode versorgenden elektrischen Stromquelle so zu modifizieren, daß die Wellenlänge der monochromatischen kontinuierlichen Laserstrahlung (10) in Abhängigkeit vom gemessenen Signal modifiziert wird.

6. Induzierter Laser (200) gemäß einem der Ansprüche 4 oder 5, bei dem das Rückkopplungssystem eine Vorrichtung aufweist, die dazu ausgelegt ist, die Modulationsfrequenz ($f_m$) und/oder die Modulationstiefe (m) der optischen Phasenmodulationsvorrichtung (20) in Abhängigkeit vom gemessenen Signal zu modifizieren.

7. Induzierter Laser (200) gemäß einem der Ansprüche 1 bis 6, bei dem das optische Verstärkungsmedium (2) aus einem Material ausgewählt ist, das eine mit Titan, Ytterbium oder Neodym dotierte Matrix aufweist.

8. Induzierter Laser (200) gemäß einem der Ansprüche 1 bis 7, bei dem die Injektionsquelle (11) eine gefaserte Laserdiode ist, die eine monochromatische kontinuierliche Laserstrahlung (10) mit einer Wellenlänge ($\lambda_c$) von 1064 nm aussendet, die optische Phasenmodulationsvorrichtung (20) einen auf einem Substrat aus Lithiumniobat integrierten optischen Modulator mit Wellenleiter aufweist, das optische Verstärkungsmedium (2) ein Neodym-YAG-Kristall ist und der getriggerte Laserresonator (3) eine Triggervorrichtung mit Q-Schalter aufweist.

9. Verfahren zum Erzeugen von longitudinalen Multimoden-Laserimpulsen (220), mit den folgenden Schritten:

- Aussenden einer monochromatischen kontinuierlichen Laserstrahlung (10),
- periodische Modulation einer Phase der monochromatischen kontinuierlichen Laserstrahlung (10) in Abhängigkeit von der Zeit bei einer Modulationsfrequenz ($f_m$), um eine polychromatische Injektionsstrahlung (120) zu erzeugen, die eine Anzahl diskreter Wellenlängen aufweist,
- Injizieren der polychromatischen Injektionsstrahlung (120) in einen getriggerten Laserresonator (3), der ein im Inneren des Laserresonators (3) angeordnetes optisches Verstärkungsmedium (2) aufweist, wobei das optische Verstärkungsmedium (2) ein spektrales Verstärkungsband aufweist, und wobei der Laserresonator einen freien Spektralbereich (ISL) aufweist, der kleiner als die spektrale Bandbreite des optischen Verstärkungsmediums (2) ist, wobei die Modulationsfrequenz ($f_m$) gleich einem ganzen natürlichen Vielfachen des freien Spektralbereichs (ISL) des Laserresonators (3) ist, damit die Anzahl diskreter Wellenlängen der polychromatischen Injektionsstrahlung (120) auf eine Anzahl longitudinaler Resonanzmoden des Laserresonators (3) abgestimmt ist, die innerhalb des Verstärkungsbands des optischen Verstärkers liegen,
- Verstärken der polychromatischen Injektionsstrahlung (120) im getriggerten Laserresonator und
- Auslösen der Ausstrahlung eines longitudinalen Multimoden-Laserimpulses (220).

## Claims

1. An injected laser (200) comprising:

- an optical amplifying medium (2) arranged inside a triggered laser cavity (3), the optical amplifying medium (2) having a spectral amplification band,
- the laser cavity (3) having a free spectral range (FSR) lower than the spectral bandwidth of the optical amplifying medium (2), the laser cavity (3) determining longitudinal resonating modes spectrally separated by the free spectral range (FSR),

in addition:

- the injected laser (200) comprises a single injection source (11) adapted to emit a monochromatic continuous laser radiation (10),
- the injected laser (200) comprises an optical phase-modulation device (20) arranged between the injection source (11) and the laser cavity (3), the optical phase-modulation device (20) being configured to periodically modulate as a function of time a phase of the monochromatic continuous laser radiation (10) at a modulation frequency ($f_m$) equal to a natural integer multiple of the free spectral range (FSR) of the laser cavity (3), so that the phase-modulated injection source generates a polychromatic injection radiation (120) having a plurality of discrete wavelengths located inside the gain band of the optical amplifier, the plurality of discrete wavelengths being tuned to a plurality of longitudinal resonance modes of the laser cavity (3),
- the laser cavity (3) and the optical amplifier medium (2) being adapted to receive said polychromatic injection radiation (120) and to generate a multi-longitudinal mode laser pulse (220).

2. The injected laser (200) according to claim 1, wherein the optical phase-modulation device (20) is configured to sinusoidally modulate the phase of the monochromatic continuous laser radiation (10) as a function of time with a modulation depth *(m),* so that the polychromatic injection radiation (120) comprises about (2. *m* +1) discrete wavelengths.

3. The injected laser (200) according to claim 2, wherein the modulation depth (*m*) is equal to about 1.4 radians so that the polychromatic injection radiation (120) comprises three discrete wavelengths.

4. The injected laser (200) according to one of claims 1 to 3, comprising a feedback-loop servo-control system comprising a measurement device adapted to measure a signal representative of a multi-longitudinal mode laser pulse (220) at the exit of the laser cavity (3) and a control device to modify, as a function of the measured signal, at least one parameter of operation of the injection source (11) and/or of the optical phase-modulation device (20) and/or of the laser cavity (3).

5. The injected laser (200) according to claim 4, wherein the injection source (11) comprises a laser diode supplied with an electric current source and wherein the feedback system comprises a device adapted to modify the power of the electric current source supplying the laser diode, so as to modify the wavelength of the monochromatic continuous laser radiation (10) as a function of the signal measured.

6. The injected laser (200) according to one of claims 4 or 5, wherein the feedback system comprises a device adapted to modify the modulation frequency ($f_m$) and/or the modulation depth *(m)* of the optical phase-modulation device (20) as a function of the signal measured.

7. The injected laser (200) according to one of claims 1 to 6, wherein the optical amplifier medium (2) is chosen among a material having a titanium-, ytterbium- or neodymium-doped matrix.

8. The injected laser (200) according to one of claims 1 to 7, wherein the injection source (11) is a fibred laser diode emitting a monochromatic continuous laser radiation (10) at a wavelength ($\lambda_c$) of 1064 nm, the optical phase-modulation device (20) comprises an optical modulator with a waveguide integrated on a lithium niobate substrate, the optical amplifying medium (2) is a neodymium-YAG crystal and the triggered laser cavity (3) comprises a Q-switch triggering device.

9. A method for generating multi-longitudinal mode laser pulses (220) comprising the following steps:

- emission of a monochromatic continuous laser radiation (10),
- periodic modulation, as a function of time, at a modulation frequency ($f_m$), of a phase of the monochromatic continuous laser radiation (10) so as to generate a polychromatic injection radiation (120) having a plurality of discrete wavelengths,
- injection of the polychromatic injection radiation (120) in a triggered laser cavity (3) comprising an optical amplifying medium (2) arranged inside the laser cavity (3), the optical amplifying medium (2) having a spectral amplification band, and the laser cavity having a free spectral band (FSR) lower than the spectral bandwidth of the optical amplifying medium (2), the modulation frequency ($f_m$) being equal to a natural integer multiple of the free spectral band (FSR) of the laser cavity (3), so that the plurality of discrete wavelengths of the polychromatic injection radiation (120) is tuned over a plurality of longitudinal resonance modes of the laser cavity (3) located inside the gain band of the optical amplifier,
- amplification of the polychromatic injection radiation (120) in the triggered laser cavity, and
- triggering of the emission of a multi-longitudinal mode laser pulse (220).

EP 3 320 586 B1

**Fig.1** (ART ANTERIEUR)

**Fig.2A**

**Fig.2B** (ART ANTERIEUR)

**Fig.2C**

**Fig.3A**

**Fig.3B** (ART ANTERIEUR)

**Fig.3C**

**Fig.4** (ART ANTERIEUR)

**Fig.5A**

**Fig.5B** (ART ANTERIEUR)

**Fig.5C**

# Fig.6

# Fig.7A

# Fig.7B

# Fig.7C

# Fig.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040233945 A1

**Littérature non-brevet citée dans la description**

- **Y.K. PARK et al.** Stable single-axial-mode operation of an unstable-resonator Nd:YAG oscillator by injection locking. *Optics Letters,* 1980, vol. 5, 96-98
- **T. RAYMOND ; A. SMITH.** Two-frequency injection-seeded Nd:YAG laser. *IEEE Journal of Quantum Electronics,* 1995, vol. 31, 1734-1737
- **D. C. KAO et al.** Development of an amplitude-modulated Nd:YAG pulsed laser with modulation frequency tunability up to 60 GHz by dual seed injection. *Optics Letters,* 2004, vol. 29, 1203-1205
- **M. KATSURAGAWA ; T. ONOSE.** Dual-wavelength injection-locked pulsed laser. *Optics Letters,* 2005, vol. 30, 1421-1423
- **T. NAKANO et al.** Dual-frequency injection-locked nanosecond pulsed laser with arbitrary combination of two oscillation frequencies. *Optics Express,* 2010, vol. 18, 26409-26416
- **Y. FUJII ; M. KATSURAGAWA.** Dual-frequency pulsed laser with an accurate gigahertz-beat note. *Optics Letters,* 2007, vol. 32, 3065-3067